# EUROPEAN PATENT APPLICATION

(11) **EP 2 447 732 A1**
(43) Date of publication of application: **02.05.2012**
(21) Application number: 10188845.1
(22) Date of filing: 26.10.2010
(51) Int. Cl.: G01R 33/36

(54) **RF antenna arrangement including a decoupling circuit especially for an MR imaging system**

(71) Applicant: Koninklijke Philips Electronics N.V., 5621 BA Eindhoven (NL); Philips Intellectual Property & Standards GmbH, 20099 Hamburg (DE)
(72) Inventor: Lips, Oliver, 5600 AE Eindhoven (NL)
(74) Representative: Damen, Daniel Martijn

(57) **Abstract**

An RF antenna or coil comprising a decoupling circuit including a parallel resonant trap circuit is disclosed for electromagnetically decoupling the RF antenna or coil from another RF antenna or coil when both RF antennas or coils are arranged in such proximity to each other that without a decoupling circuit couplings between both RF antennas or coils have to be expected which might lead to a decrease of the signal to noise ratio of received and/or transmitted RF signals or which couplings might lead to other detrimental effects. Further, an RF transmit/receive antenna arrangement especially for an MR (magnetic resonance) imaging system or scanner is disclosed, wherein the RF transmit/receive antenna arrangement comprises an RF transmit antenna or coil which is preferably provided only for transmitting RF signals, and an RF receive antenna or coil which is preferably provided only for receiving MR signals (i.e. "dedicated" RF antennas or coils), wherein at least one of theses RF antennas or coils is provided with a decoupling circuit according to the invention.

## Description

### FIELD OF THE INVENTION

The invention relates to an RF antenna or coil comprising a decoupling circuit for electromagnetically decoupling the RF antenna or coil from another RF antenna or coil when the latter is operated and when both RF antennas or coils are arranged in such proximity to each other that without a decoupling circuit couplings between both RF antennas or coils have to be expected which might lead to a decrease of the signal to noise ratio of received and/or transmitted RF signals or which couplings might lead to other detrimental effects.

Further, the invention relates to an RF transmit/receive antenna arrangement especially for an MR (magnetic resonance) imaging system or scanner, wherein the RF transmit/receive antenna arrangement comprises an RF transmit antenna or coil which is preferably provided only for transmitting RF signals, and an RF receive antenna or coil which is preferably provided only for receiving MR signals (i.e. "dedicated" RF antennas or coils), wherein at least one of theses RF antennas or coils is provided in the form of an RF antenna or coil as mentioned above.

Finally, the invention relates to an MR imaging system or scanner comprising an RF antenna or coil as mentioned above or an RF transmit/receive antenna arrangement as mentioned above.

In case of MR imaging systems or scanners, the RF antennas are usually called RF coils. However, the applicability of the RF antennas according to the invention is not limited to MR imaging systems or scanners, but can be used in all other RF systems in which RF antennas have to be decoupled from each other in the sense above.

### BACKGROUND OF THE INVENTION

In an MRI system or MR scanner, an examination object, usually a patient, is exposed to a uniform main magnetic field (B₀ field) so that the magnetic moments of the nuclei within the examination object tend to rotate around the axis of the applied B₀ field (Larmor precession) with a certain net magnetization of all nuclei parallel to the B₀ field. The rate of precession is called Larmor frequency which is dependent on the specific physical characteristics of the involved nuclei and the strength of the applied B₀ field.

By transmitting an RF excitation pulse (B₁ field) which is orthogonal to the B₀ field, generated by means of an RF transmit antenna or coil, and matching the Larmor frequency of the nuclei of interest, the spins of the nuclei are excited and brought into phase, and a deflection of their net magnetization from the direction of the B₀ field is obtained, so that a transversal component in relation to the longitudinal component of the net magnetization is generated.

After termination of the RF excitation pulse, the relaxation processes of the longitudinal and transversal components of the net magnetization begin, until the net magnetization has returned to its equilibrium state. MR relaxation signals which are emitted by the relaxation processes, are detected by means of an RF receive antenna or coil.

The received MR signals which are time-based amplitude signals, are Fourier transformed to frequency-based MR spectrum signals and processed for generating an MR image of the nuclei of interest within an examination object.

The above RF (transmit and/or receive) antennas or coils can be provided both in the form of so-called MR body coils (also called whole body coils) which are fixedly mounted within an examination space of an MRI system for imaging a whole examination object, and as so-called MR surface coils which are directly arranged on a local zone or area to be examined and which are constructed e.g. in the form of flexible pads or sleeves or cages (e.g. head coil or birdcage coil). All these RF antennas or coils can be provided according to the invention.

Generally, it can be distinguished between RF transmit/receive antennas or coils which are used both for transmitting and receiving, and RF antenna arrangements which comprise dedicated RF transmit antennas or coils and dedicated RF receive antennas or coils which are each used for the transmission of RF excitation pulses only and for the reception of the MR signals only, respectively.

In the latter case, to which the invention is especially related, the problem may arise that each one of the RF antennas or coils electromagnetically couples with the other RF antenna of coil during this other is operated for RF signal transmission or RF signal reception due to e.g. their close positioning within an MR imaging system or scanner or for other reasons. It is common in the MR related prior art to detune each one of the two RF antennas or coils during the operation of the each other of the two RF antennas or coils in order to avoid or reduce such a coupling between both, and in order to either protect the sensitive receiver circuits during the transmission of the comparatively strong RF excitation signals by means of the RF transmit antenna or coil, and/or to prevent a deterioration of the signal to noise ratio (SNR) of the MR relaxation signals during the reception of these signals by means of the RF receive antenna or coil.

Finally, as to the shape of the examination space, two types of MRI systems or MR scanners can be distinguished. The first one is the so-called open MRI system (vertical system) which comprises an examination zone, which is located between the ends of a vertical C-arm arrangement. The second one is an MRI system, also called axial MRI system, which comprises a horizontally extending tubular or cylindrical examination space. The RF antennas or coils according to the invention can be used in both of these systems.

### SUMMARY OF THE INVENTION

Generally, for decoupling the above RF antennas or coils from each other, a diode can be serially connected into at least one of the conductors of the resonant conductor structure of the RF antenna or coil which diode is biased in a forward or reverse direction, thus realizing a conductive or non-conductive element, respectively. In order to detune the related RF antenna or coil, the serially connected diode is biased non-conductive so that the resonance frequency of the RF antenna or coil is shifted and by this the RF antenna or coil is decoupled from the other one.

However, in case of such a serial connection of a diode and when applying the RF antenna or coil for transmitting signals, the diode is in a conducting state during the RF transmission so that it must be able to carry a high current (usually more than 50 A) and to dissipate the corresponding high power. Due to these high currents, several high power diodes have to be connected in parallel, however, such diodes have to be selected appropriately such that a non-equal current distribution among the parallelized diodes is avoided.

Further, in the non-conducting state, in which the diodes are used for detuning the RF antenna or coil, the problem often arises that the related RF antenna or coil is not detuned sufficiently. This is due to the fact that the diodes in the reverse or off-state (i.e. non-conducting) present a capacitor which blocks the RF current by its impedance, but the more diodes are connected in parallel, the larger this capacitor is and the less impedance blocks the RF current. This has the consequence, that the resonance frequency of the related RF antenna or coil is accordingly less shifted and by this the RF antenna or coil is insufficiently detuned and accordingly insufficiently decoupled from the other RF antenna or coil.

Alternatively, in case of a parallel connection of a diode into a resonant conductor structure of an RF transmit antenna or coil, the diode is reversely biased and is non-conductive during the RF transmission so that it must be able to withstand high voltages. This requires high demands on the diode which accordingly results in high costs.

One object underlying the invention is to provide an RF antenna or coil as mentioned in the introductory part, which can effectively be decoupled from a proximate other RF antenna or coil without causing the above explained problems.

This object is solved according to claim 1 by an RF antenna or coil comprising a resonant conductor structure for exciting during the operation of the RF antenna or coil resonant RF currents at a resonance frequency of the RF antenna or coil for transmitting and/or receiving RF signals, wherein the resonant conductor structure comprises a trap circuit being serially connected into one conductor of the resonant conductor structure and comprising a first conductor loop which is provided by:
- a first and a second conductor which are connected in parallel, wherein:
- at least one reactive element being connected in series into the second conductor, or at least one parallel connection of at least two reactive elements being connected in series into the second conductor, and
- a switch being connected in series into the second conductor and in parallel to at least one of the reactive elements for short-circuiting the at least one reactive element in a conducting state of the switch, wherein the inductance and/or the capacitance of the at least one reactive element is selected such that:
- when the switch is switched in its non-conducting state, the trap circuit can resonate at a trap resonance frequency which is at least substantially equal to the resonance frequency of the RF antenna or coil, so that the resonant RF currents at the resonance frequency of the RF antenna or coil are trapped by the trap circuit, and
- when the switch is switched in its conducting state, the trap resonance frequency cannot be excited so that the resonant RF currents at the resonance frequency of the RF antenna or coil can be excited in the resonant conductor structure.

In other words, in the non-conducting state of the switch (which can be a micro-mechanical switch or a semiconductor switch, especially a diode) the decoupling is obtained by the trap resonance of the trap circuit which by its high impedance interrupts the said conductor of the resonant conductor structure of the RF antenna or coil and by this detunes the RF antenna or coil by suppressing or shifting its resonance frequency to one or more other frequencies. This detuning is much more effective than in the above explained case of using several diodes in parallel in non-conducting state.

In the conducting state of the switch the trap resonance cannot be excited because at least one reactive element of the trap circuit is short-circuited by the switch so that the impedance of the trap circuit at least at the resonance frequency of the RF antenna or coil is low and the resonant conductor structure of the RF antenna or coil is not effectively interrupted so that RF currents at the resonance frequency of the RF antenna or coil can be excited.

Apart from the improved detuning, this solution has the further advantage that in the conducting state of the switch in which the RF antenna or coil is operating at its (original) resonance frequency, the resonant current through the switch is reduced to about a half or less due to the distribution of resonant current over the first and the second conductor.

The RF antenna or coil according to the invention is preferably used as an RF transmit antenna or coil for decoupling the same from an RF receive antenna or coil during RF signal reception. The RF antenna or coil according to the invention can also be used as an RF receive antenna or coil (for detuning the same during RF signal transmission), however, the advantage of reducing the resonant current carried by the switch (especially in case of a semiconductor switch like a diode) and thus reducing the requirements therefore is specific to RF transmit coils because in RF receive coils these resonant currents are considerably smaller anyway.

Finally, the principle of the invention can also be used in RF transmit and/or receive antennas which are provided for other applications than MR imaging. The dependent claims disclose advantageous embodiments of the invention.

The embodiment according to claim 2 has the advantage that by the second conductor loop an increased inductance (namely together with the first conductor loop) is obtained for the trap circuit so that the extension of both loops together can be kept smaller than the extension of the (first) conductor loop in case of using only one such loop, wherein the two (or more than two) conductor loops can all have the same or different sizes and/or extensions. Further, by the second conductor loop the resonant current through the switch in its conducting state is further reduced to about a third or less. In the same way, a third and further conductor loops could be provided by means of further conductors being connected in parallel to the first conductor.

The embodiment according to claim 3 is provided for a semiconductor switch having a separate control terminal.

According to claim 4, the preferred embodiment of the semiconductor switch is a diode, especially a PIN diode. The above advantage with respect to the reduction of the resonant current of the RF antenna or coil through the switch is especially relevant in case of such a diode, because due to the reduced current in the conducting state it is not necessary to connect several diodes in parallel, and the related problems mentioned above are avoided.

According to claim 6, the reactive element is a capacitor or an inductor, wherein in case of more than one reactive element each such element can be capacitor or an inductor. Generally, the selection of the kind of the reactive element(s), its number and its capacitance and inductance, respectively, is selected in dependence of the inductance of the at least one conductor loop and the possible capacitance of the semiconductor switch (claim 5) in its non conducting state such that a trap circuit is obtained having a trap resonance frequency which is at least substantially equal to the resonance frequency of the RF antenna or coil.

According to claims 7 and 8, further reactive elements can be provided for appropriately tuning the trap resonance frequency.

According to claim 9, the RF antenna or coil is preferably a TEM-type or micro-strip antenna or coil which is based on a TEM or micro-strip design because such designs typically provide a geometry and a width of the conductor strips or lines (in comparison to conductor wires) which is sufficient to easily incorporate two (or more) parallel conductors forming one (or more) conductor loop(s) for realizing the trap circuit according to the invention. Nevertheless, the trap circuit can also be incorporated into other antenna or coil designs having other kinds of conductors like conductor wires.

Claims 10 and 11 disclose advantageous RF transmit/receive antenna arrangements comprising an RF antenna according to the invention.

Finally, claim 12 discloses an MR imaging system or scanner comprising an RF antenna according to the invention.

It will be appreciated that features of the invention are susceptible to being combined in any combination without departing from the scope of the invention as defined by the accompanying claims.

Further details, features and advantages of the invention will become apparent from the following description of preferred and exemplary embodiments of the invention which are given with reference to the drawings.

### BRIEF DESCRIPTION OF THE DRAWINGS

Fig. 1 shows a first embodiment of a trap circuit according to the invention representing a first switching state;
   Fig. 2 shows the first embodiment according to Figure 1 for representing a second switching state;
Fig. 3 shows a second embodiment of a trap circuit according to the invention;
Fig. 4 shows a third embodiment of a trap circuit according to the invention;
Fig. 5 shows a fourth embodiment of a trap circuit according to the invention;
Fig. 6 shows a fifth embodiment of the trap circuit according to the invention;
Fig. 7 shows a sixth embodiment of a trap circuit according to the invention;
Fig. 8 shows a generalized trap circuit according to the invention;
Fig. 9 schematically shows a first TEM type resonator incorporating a trap circuit according to the invention;
Fig. 10 schematically shows a second TEM type resonator incorporating a trap circuit according to the invention;
Fig. 11 shows diagrams of the input impedance of the resonator according to Figure 9 in a tuned and a detuned state, respectively;
Fig. 12 shows a diagram of the simulated magnetic field of the resonator according to Figure 9 in a tuned state;
Fig. 13 shows a diagram of the simulated magnetic field of the resonator according to Figure 9 in a detuned state;
Fig. 14 shows a diagram of the simulated magnetic field of the resonator according to Figure 9 with an additional inductor in a tuned state; and
Fig. 15 shows a diagram of the simulated magnetic field of the resonator according to Figure 9 with an additional inductor in a detuned state.

### DETAILED DESCRIPTION OF EMBODIMENTS

In all Figures, the same or corresponding components or elements are each denoted with the same or corresponding reference signs.

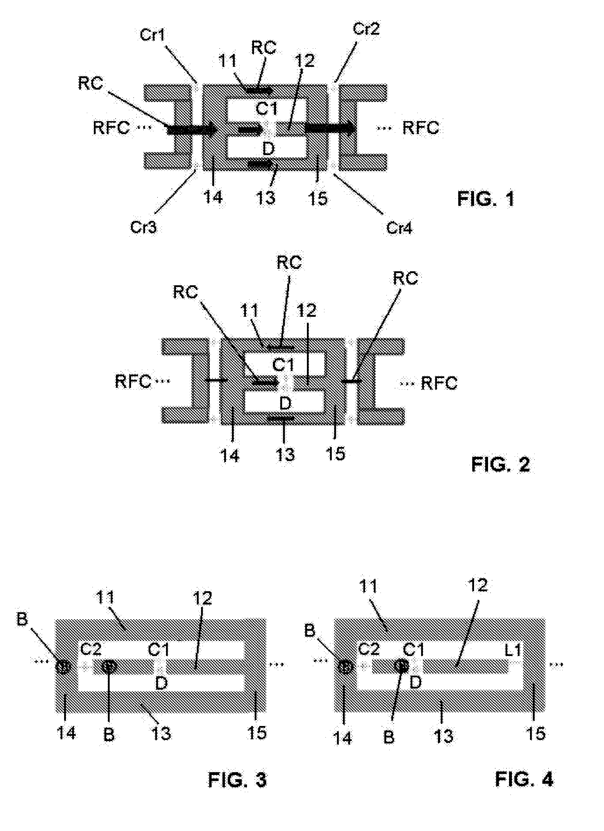

In this application, a serial connection or coupling of a (reactive) element (or of a switch) into a conductor means that the related conductor is electrically interrupted and the interruption is bridged by the element (or switch) as indicated and explained below with reference to Figures 1 to 10.

Generally, a decoupling of a first RF antenna or coil from a second RF antenna or coil is obtained by the known high impedance of a trap circuit (decoupling circuit), when resonating at its trap resonance, and the resulting detuning of the first RF antenna or coil in which the trap circuit is realized. The trap circuit is serially connected or coupled (e.g. by means of capacitors) into a conductor of the resonant conductor structure of the RF antenna or coil. For ease of dimensioning, the trap circuit is preferably formed by two conductor loops and at least one reactive element which is serially connected into at least one of the conductors forming the conductor loops, wherein the at least one reactive element is formed each by at least one capacitor and/or at least one inductor which, if applicable, can be connected in parallel or in series. On the basis of a given size and given dimensions of the two conductor loops (especially with respect to geometric conditions) and their inductances and a possible capacitance of the semiconductor switch in its non conducting state, the at least one reactive element is selected such that the trap resonance is at least substantially equal to the resonance frequency of the RF antenna coil in its tuned state.

For switching the RF antenna or coil between a tuned state and a detuned state, the trap circuit comprises a switch, preferably a semiconductor switch like a diode, which is connected in parallel to at least one of the reactive elements and which can be switched between a conducting state and a non conducting state, wherein the conducting state short-circuits the reactive element and by this detunes or deactivates the trap circuit, and the non conducting state enables the excitation of a trap resonance and by this activates the trap circuit and consequently detunes the RF antenna or coil.

Especially in case of an RF antenna or coil with a resonant conductor structure which comprises strip lines or strip conductors (like e.g. in a conductor structure on a printed circuit board) as schematically indicated in Figures 1 to 10 instead of conductor wires, it is further preferred that the conductors of the trap circuit are formed by accordingly shaping one of the given conductors (or a part thereof) of the resonant conductor structure of the RF antenna or coil in the form of said at least one conductor loop and by serially connecting into it at least one reactive element as disclosed above and in the following.

For the reasons mentioned above, the trap circuit according to the invention is preferably provided for detuning an RF transmit antenna or coil during MR signal reception.

In the following Figures 1 to 8 only trap circuits in various embodiments according to the invention are shown, whereas the other parts of the RF antenna or coil (indicated in the form of dots in these Figures) are not shown and can be designed as known in the prior art. However, the same and other embodiments as shown in Figures 1 to 8 can also be realized by means of conductor wires which are provided in the form of the indicated two conductor loops or in the form of one or more than two conductor loops. Further, all of the conductor loops can have different sizes and/or extensions and/or other forms or shapes than those shown in Figures 1 to 8 (like curved, circular, oval etc.) as long as they provide an inductance which in combination with the appropriately selected reactive elements and a possible capacitance of the switch in its non conducting state provide a trap resonance which is at least substantially equal to the resonance of the RF antenna or coil in its tuned state as explained above.

Figures 1 and 2 show a general structure of a trap circuit according to the invention in the form of a first embodiment, being a part of a resonant conductor structure of an RF antenna or coil which is denoted by "RFC" in these Figures. The trap circuit is serially coupled into the resonant conductor structure of the RF antenna or coil RFC preferably by means of capacitors Cr1, Cr2, Cr3, Cr4 which are preferably provided also for tuning the resonance frequency of the RF antenna or coil for RF/MR signal transmission and/or reception as generally known.

The trap circuit preferably comprises a first, a second and a third conductor 11, 12, 13 which are connected in parallel by means of a fourth and a fifth conductor 14, 15, so that two conductor loops are formed. As mentioned above, also more than three conductors can be connected in parallel or in another way so that more than two conductor loops having the same or different dimensions are formed. This applies for all embodiments explained in the following and for any other embodiments as well.

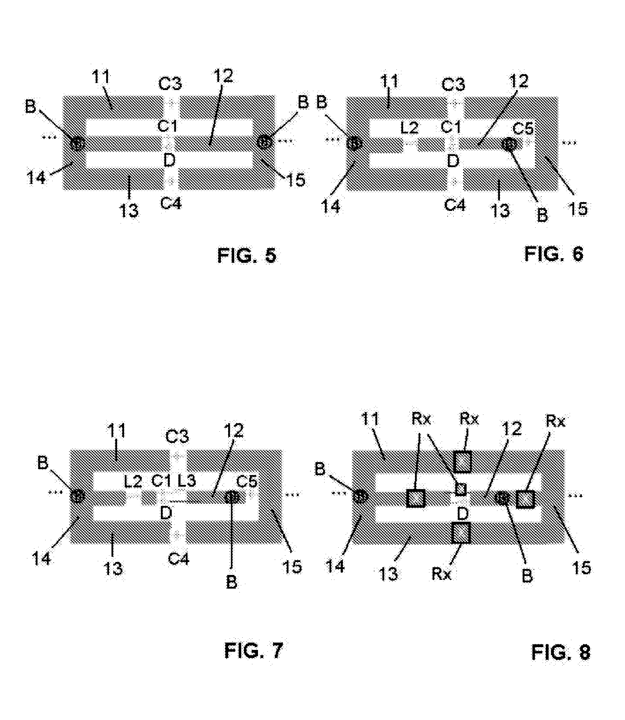

Further, a parallel connection of a semiconductor switch in the form of a diode D (preferably a PIN diode) and a reactive element Rx (see Figure 8), which in the embodiments according to Figures 1 to 6 is a first capacitor C1, is provided, wherein this parallel connection preferably is serially connected into one of the three parallel conductors 11, 12, 13, preferably into the second or middle conductor 12 which is arranged between the first and the third conductor 11,13 and by this is a common conductor of both conductor loops.

In Figures 1 and 2, also the current distribution in the trap circuit is indicated by arrows (which are denoted by "RC"), resulting from a conducting and a non conducting state of the diode D, respectively. More in detail, Figure 1 shows a conducting state of the diode D in which the diode D is supplied with a DC current in forward direction, so that the first capacitor C1 is short-circuited. In Figure 2, the current distribution is indicated by the arrows RC for a non conducting state in which the diode D is reversely biased by a DC voltage, namely biased in the opposite or reverse direction so that the first capacitor C1 is effective.

In the conducting state according to Figure 1, the total current through the trap circuit is determined by the resonator current of the RF antenna or coil RFC. This total current is substantially evenly distributed over the three parallel conductors 11, 12, 13 of the trap circuit. By this, the current through the diode D is significantly reduced in comparison to the total current, namely by about one third in the indicated case of three parallel conductors. In this conducting state of the diode D, the trap circuit has a low impedance and the RF antenna or coil can be operated in the tuned state at its desired resonance frequency for transmitting (or receiving) RF signals.

In the non conducting state of the diode D according to Figure 2 and as indicated by the arrows RC, a trap resonance e.g. in the form of a "butterfly-type" current mode is tuned by the first capacitor C1 (and by its appropriately selected capacitance) and is excited in the three parallel conductors 11, 12, 13, in which the currents in the first and the third conductor 11,13 (outer conductors) are flowing in a direction which is opposite to the direction of the current in the second conductor 12 (middle or inner conductor, common to both conductor loops). By this trap resonance the trap (or decoupling) circuit forms a high impedance so that it effectively traps or blocks or at least reduces any currents of the RF antenna or coil at its above resonance frequency through the conductor of the resonant conductor structure, into which the trap circuit is serially connected and by this suppresses the resonance frequency.

Possibly, instead of this original resonance frequency, one or more other resonance frequencies may occur in the RF antenna or coil depending on the position of the trap circuit within the resonant conductor structure of the RF antenna or coil and the resonance properties of the remaining conductor structures which are electrically separated by the high impedance of the trap circuit. In order to sufficiently shift these other resonance frequencies away from the original resonance frequency (if necessary in order to obtain a sufficient decoupling), the position of the trap circuit within the conductor structure of the RF antenna or coil is appropriately selected, and/or more than one trap circuit is connected at different positions into the resonant conductor structure of the RF antenna or coil.

By this, in case of an RF transmit antenna or coil, the latter can appropriately be decoupled from an RF receive antenna or coil, so that RF signals can be received by the latter with a substantially increased signal to noise ratio (SNR) in comparison to a not detuned RF transmit antenna or coil.

Generally, it has revealed that in most cases and on the basis of given resonance frequency ranges of RF and MR signals in MR technology, the conductor loops of the trap circuit can first be shaped and dimensioned considering the surrounding geometrical conditions in an MR imaging system or scanner, and than the required trap resonance can be tuned by accordingly selecting the capacitance of the first capacitor C1 in parallel to the diode D without the need for any further reactive elements in the trap circuit, especially in case that two conductor loops are provided as indicated in Figure 1.

However, for reducing the current through the diode D even further, if desired, an additional inductor can be serially connected to the diode D (or, in other words, into the conductor which includes the diode D). In this case, the capacitance of the first capacitor C1 in parallel to the diode D is preferably made correspondingly smaller in order to keep the trap resonance unchanged.

Figures 3 to 8 show further embodiments of a trap circuit according to the invention. In these embodiments also exemplary terminals B for connecting the forward and reverse DC biasing voltage or current to the diode D are indicated.

More in detail, Figure 3 shows a second embodiment of a trap circuit, again comprising a first, a second and a third conductor 11, 12, 13, connected in parallel to each other by means of a fourth and a fifth conductor 14, 15, wherein the second or middle conductor 12 comprises in series the parallel connection of the diode D and the first capacitor C1 as explained above with reference to Figures 1 and 2.

Additionally, Figure 3 shows a second capacitor C2 in the form of a DC blocking capacitor which connects a first end of the second conductor 12 with the fourth conductor 14 (or is serially connected into a portion of the second conductor 12 between the diode D and this first end of the second conductor 12, which is electrically the same). Further, at both sides of the DC blocking capacitor C2, connecting terminals B are provided for applying the DC bias voltage or current for the diode D. Usually, the capacitance of such a DC blocking capacitor is chosen such (especially large enough) that the resonant current of the RF antenna or coil and the trap resonance frequency are not or not substantially influenced. Apart from this DC blocking capacitor C2 and the connecting terminals B for applying the DC bias voltage or current, this embodiment is the same as the first embodiment shown in Figures 1 and 2.

Figure 4 shows a third embodiment of a trap circuit according to the invention. In comparison to the second embodiment shown in Figure 3, this third embodiment additionally comprises a first inductor L1, preferably in the form of a lumped inductor, which connects a second end of the second conductor 12 with the fifth conductor 15 (or is serially connected into a portion of the second conductor 12 between the diode D and this second end of the second conductor 12, which is electrically the same).

As mentioned above, by such an inductor L1, the current during the tuned state (i.e. conducting state of the diode D) of the RF antenna or coil in the second conductor 12 is reduced, whereas the current in the first and in the third conductor 11,13 increases. Thus, an even smaller diode D can be used. However, as mentioned above, the capacitance of the first capacitor C1 in parallel to the diode D has to be readjusted for the non conducting state of the diode D in order to compensate for the additional inductor L1 and to keep the above explained trap resonance for decoupling the RF antenna or coil unchanged.

Figure 5 shows a fourth embodiment of a trap circuit according to the invention in which in comparison to the first embodiment shown in Figures 1 and 2, a third capacitor C3 is serially connected into the first conductor 11 and a fourth capacitor C4 is serially connected into the third conductor 13. By appropriately selecting the capacitance of these capacitors C3, C4, together with the first capacitor C1 in parallel to the diode D, the trap resonance in the non conducting state of the diode D can be tuned. Further, the third and the fourth capacitor C3, C4 can additionally have the function of DC blocking capacitors, so that two connecting terminals B at the opposite ends of one of the first to third conductor 11, 12, 13 or at each one of the fourth and fifth conductor 14, 15 can be provided for applying the DC bias voltage or current at the diode D as explained above.

Figure 6 shows a fifth embodiment of a trap circuit according to the invention in which in comparison to the fourth embodiment according to Figure 5 a second inductor L2, preferably in the form of a lumped inductor, is serially connected into a portion of the second conductor 12 between the diode D and the first end of the second conductor 12 (or which connects this first end of the second conductor 12 with the fourth conductor 14, which is electrically the same). Further, a fifth capacitor C5 is provided which connects the second end of the second conductor 12 with the fifth conductor 15 (or is serially connected into a portion of the second conductor 12 between the diode D and this second end of the second conductor 12, which is electrically the same).

The connecting terminals B for applying the DC bias voltage or current for the diode D are provided at the second conductor 12 between the diode D and the fifth capacitor C5 and at the fourth conductor 14, respectively.

By the second inductor L2, again the current during the tuned state through the second conductor 12 and through the diode D is reduced, and is accordingly increased in the first and the third conductor 11, 13. The third, the fourth and the fifth capacitor C3, C4, C5 is again provided together with the first capacitor C1 in parallel to the diode D in order to tune the trap resonance during the non conducting state of the diode D. Further, at least one of the third, the fourth and the fifth capacitor C3, C4, C5 can additionally fulfill the function of a DC blocking capacitor for applying the DC bias voltage or current for the diode D at the connecting terminals B.

Figure 7 shows a sixth embodiment of a trap circuit according to the invention. In comparison to the embodiments as shown in Figures 1 to 6 in which the reactive element which is connected in parallel to the diode D is the first capacitor C 1 only, in the embodiment according to Figure 7, this reactive element is a serial connection of the first capacitor C1 and a third inductor L3. The third inductor L3 is provided together with the other reactive elements C1, C3, C4, C5 and L2 (which are connected into the trap circuit as explained above with reference to Figures 3 to 6) such that when the diode D is in the non conducting state, a trap resonance can be excited, which effectively traps or blocks the resonant current of the RF antenna and by this detunes this RF antenna or coil as explained above.

Figure 8 shows a generalized trap circuit according to the invention in which the various possible positions of reactive elements Rx which are serially connected into at least one of the first, the second and the third conductor 11, 12, 13 and in parallel to the diode D are indicated. Each reactive element Rx can be at least one capacitor C and/or at least one inductor L and/or a serial and/or a parallel connection of at least one capacitor and/or at least one inductor. It is also possible that all reactive elements, as far as they are provided, are inductors only but not comprising any capacitor, if the capacitance of the diode D in its non conducting state is large enough to obtain the desired trap resonance frequency. The same applies accordingly for the reactive elements in the form of capacitors only, if the inductance of the at least one conductor loop is large enough to obtain the desired trap resonance frequency.

If a capacitor at any position within the trap circuit is provided for avoiding a short-circuit of the DC bias voltage/current source only (i.e. a "DC blocking capacitor") but not for tuning the trap resonance, the capacitance of such a capacitor is typically chosen such (especially large enough or having an appropriate small value depending on the other reactive elements Rx) that the RF current through the trap circuit and the trap resonance frequency are not or not substantially influenced. However, the capacitors C3, C4, C5 or other capacitors which are used for tuning the trap resonance can be used additionally as DC blocking capacitors also.

Consequently, a large variety of configurations including the positions of the connecting terminals B for applying the DC bias voltage/current for the diode D in the reverse direction and/or for supplying a DC current in the forward direction can be realized.

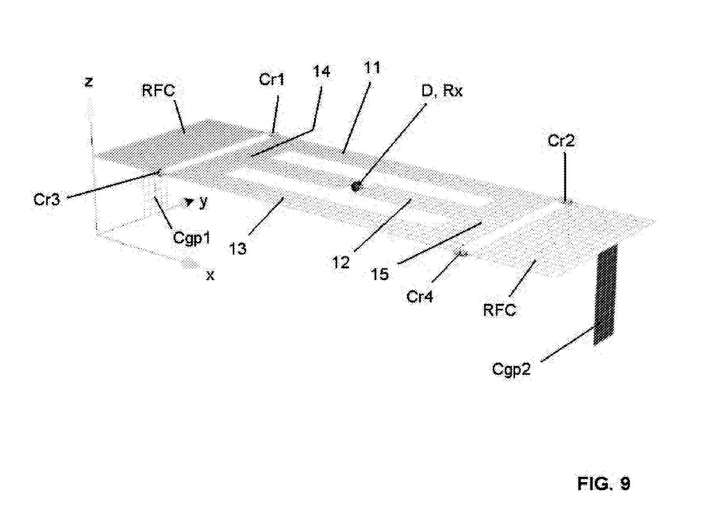

Figure 9 shows a first embodiment of an RF antenna in the form of a known TEM type resonator (denoted by "RFC") incorporating a trap circuit according to the invention. On the basis of the indicated Cartesian coordinate system it is assumed that in the x/y-plane at z = 0 a ground plane or screen in the form of an electrically conducting surface extends and that the resonant conductor structure of the TEM type resonator extends in an x/y-plane above this ground plane at z > 0. Additionally, the resonant conductor structure comprises a connection as known from the prior art to the ground plane in the form of a first ground plane connection Cgp1 at a first side and a second ground plane connection Cgp2 at an opposite second side of the main conductor structure.

The resonant conductor structure of the TEM resonator comprises the trap circuit according to the invention, namely the first, the second and the third conductor 11, 12, 13 which are connected in parallel by means of the fourth and the fifth conductor 14, 15 for providing the two conductor loops as described above with respect to Figures 1 to 8. Into the second conductor 12 again the parallel connection of the diode D and the reactive element Rx as explained above with respect to Figures 1 to 8 is serially connected.

The trap circuit is connected with the other portions of the resonant conductor structure of the TEM resonator preferably by means of a first, a second, a third and a fourth capacitor Cr1, Cr2, Cr3, Cr4 as indicated in and explained with respect to Figure 1 for tuning the resonance frequency of the TEM resonator.

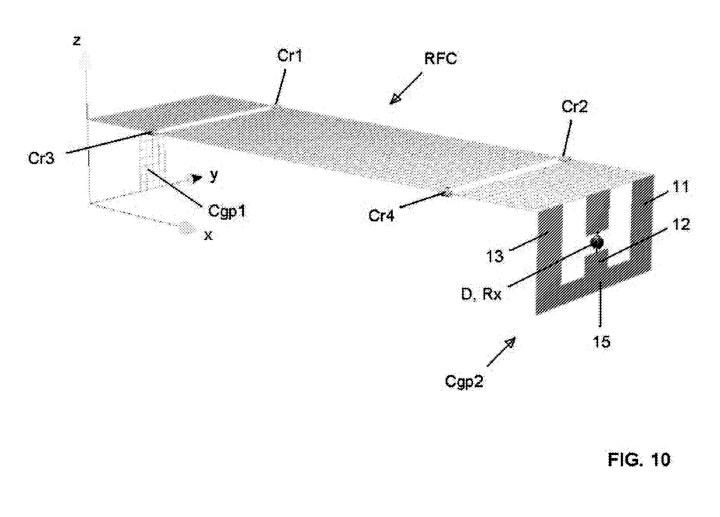

Figure 10 shows a second embodiment of an RF antenna in the form of a known TEM type resonator RFC incorporating a trap circuit according to the invention. The same or corresponding parts as in Figure 9 are each denoted with the same reference signs so that only the differences between both embodiments need to be explained.

In this embodiment, the resonant conductor structure of the TEM resonator in the x/y plane at z > 0 is provided as known from the prior art, and one of its ground plane connections Cgp1, Cgp2 is provided in the form of a trap circuit according to the invention. This trap circuit again comprises two conductor loops formed by the first, the second and the third conductor 11, 12, 13, wherein into the second conductor 12 again the parallel connection of the diode D and the reactive element Rx is serially connected. At one of their ends, the first, the second and the third conductors 11, 12, 13 are connected with the part of the resonant conductor structure in the x/y plane, wherein the opposite other ends of these conductors are connected by means of the fifth conductor 15 which is connected with the ground plane at z = 0.

For the sake of clarity only, neither in Figure 9 nor in Figure 10, the various other reactive elements Rx which can be connected into the trap circuit according to the invention and as indicated in Figure 8, nor the connecting terminals B for applying the DC bias voltage/current at the diode D are indicated.

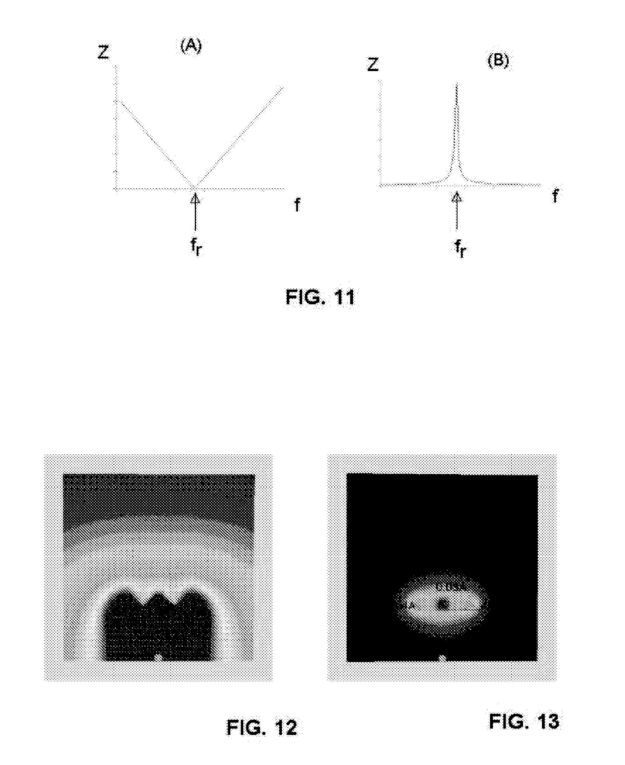

Figure 11(A) shows a diagram of the input impedance Z over the frequency f of a TEM resonator according to Figure 9 for the tuned state in which the diode D is in a conducting state. At the resonance frequency fr of the TEM resonator, this input impedance has been measured to be smaller than 0.2 Ohm. Figure 11(B) shows this input impedance Z for the detuned state in which the diode D is in a non conducting state and the trap circuit is resonating at its trap resonance frequency (which is substantially the same as the resonance frequency fr of the TEM resonator). In this case the input impedance Z has been measured to be greater than 6 kOhm at this resonance frequency.

Figure 12 shows a diagram of the simulated magnetic field strength H of the TEM resonator according to Figure 9 in a tuned state in the y/z-plane. The current distribution on the first to third conductor 11, 12, 13 of the above trap circuit can be recognized in this diagram to be nearly even. In comparison to this, Figure 13 shows the magnetic field strength H in the detuned state, i.e. the diode is non-conducting, in which the butterfly-type current mode is generated. Figure 13 shows that this magnetic field strength is significantly smaller and decreases much faster with the distance from the conductors in comparison to the magnetic field strength in the TEM resonant mode indicated in Figure 12. It is to be noted that in Figure 12 the scale of the magnetic field strength H has a maximum of 100 A/m between the conductor structure and the ground plane (dark area), whereas in Figure 13 this scale has a maximum of only about 5.6 A/m.

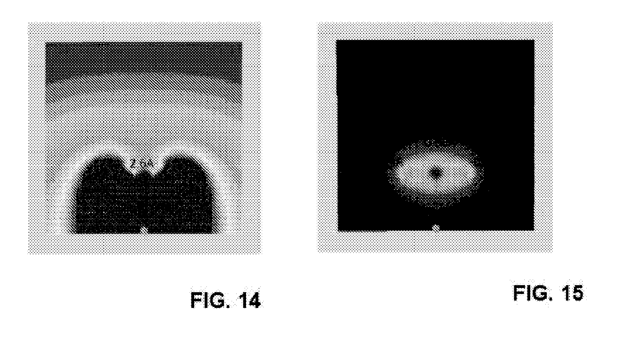

If an inductor like the first or the second inductor L1, L2 is incorporated into the second conductor 12 as shown in Figure 4, Figure 6 and Figure 7, respectively, the current through this second conductor 12 (and by this the current through the diode D) is reduced and the current through the first and third conductor 11, 13 is increased in the tuned state. This can be recognized in the diagram of the simulated magnetic field strength H of the TEM resonator according to Figure 14 in the form of an accordingly reduced magnetic field strength H at this second (middle) conductor and an increased magnetic field strength at the first and third conductor in comparison to Figure 12. In the detuned state according to Figure 15, the magnetic field strength is nearly unchanged by such an additional inductor in comparison to Figure 13 which results without such an inductor L1, L2 in the detuned state. The maximum scale of the magnetic field strength H in Figures 14 and 15 is the same as in Figures 12 and 13, respectively.

The efficiency of the trap circuit according to the invention has been verified by experiments in which a TEM resonator according to Figure 9 has been constructed for a resonance frequency of about 105 MHz and pick-up coils have been placed close to such a TEM resonator. In the tuned state of the TEM resonator (in which the diode D of the trap circuit is conducting), the coupling between the TEM-resonator and the pick-up coil was about -20 dB. By detuning the TEM resonator (by DC biasing the diode D non-conducting), the original resonance frequency of 105 MHz has been shifted to a lower resonance frequency at about 77 MHz and a higher resonance frequency of about 121 MHz. By this, the coupling at the original resonance frequency of 105 MHz was decreased to about -84 dB, i.e. the coupling was reduced by 64dB. Further, no adverse effects of the trap resonance of the trap circuit could be detected.

While the invention has been illustrated and described in detail in the drawings and foregoing description, such illustration and description are to be considered illustrative or exemplary and not restrictive, and the invention is not limited to the disclosed embodiments. Variations to embodiments of the invention described in the foregoing are possible without departing from the scope of the invention as defined by the accompanying claims. This especially applies for the diode D instead of which another semiconductor switch or a micro-mechanical switch can be used, as well as for the resonant conductor structures of the related RF antenna, which can be provided as conductor wires instead of strip lines or strip conductors.

Variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. RF antenna or coil comprising a resonant conductor structure for exciting during the operation of the RF antenna or coil resonant RF currents at a resonance frequency of the RF antenna or coil for transmitting and/or receiving RF signals, wherein the resonant conductor structure comprises a trap circuit being serially connected into one conductor of the resonant conductor structure and comprising a first conductor loop which is provided by:
- a first and a second conductor (11, 12) which are connected in parallel, wherein:
- at least one reactive element (Rx) being connected in series into the second conductor (12), or at least one parallel connection of at least two reactive elements (Rx) being connected in series into the second conductor (12), and
- a switch being connected in series into the second conductor (12) and in parallel to at least one of the reactive elements (Rx) for short-circuiting the at least one reactive element (Rx) in a conducting state of the switch, wherein the inductance and/or the capacitance of the at least one reactive element (Rx) is selected such that:
- when the switch is switched in its non-conducting state, the trap circuit can resonate at a trap resonance frequency which is at least substantially equal to the resonance frequency of the RF antenna or coil, so that the resonant RF currents at the resonance frequency of the RF antenna or coil are trapped by the trap circuit, and
- when the switch is switched in its conducting state, the trap resonance frequency cannot be excited so that the resonant RF currents at the resonance frequency of the RF antenna or coil can be excited in the resonant conductor structure.

2. RF antenna or coil according to claim 1,
wherein the trap circuit comprises a second conductor loop which is provided by means of a third conductor (13) and the second conductor (12), wherein the third conductor (13) is connected in parallel to the second conductor (12), for enabling the excitation of a resonant butterfly type current mode within the first and the second conductor loop when the switch is in its non-conducting state.

3. RF antenna or coil according to claim 1,
wherein the switch is a semiconductor switch which can be switched between the conducting state and the non-conducting state by means of a related control voltage which is applied at a control terminal of the semiconductor switch.

4. RF antenna or coil according to claim 3,
wherein the semiconductor switch is a diode (D) and wherein a DC blocking capacitor (C2) is connected into the first conductor loop such that at the terminals of the DC blocking capacitor a DC bias current or voltage can be applied for operating the diode (D) in a conducting state and in a non-conducting state, respectively.

5. RF antenna or coil according to claim 3,
wherein in the non-conducting state the semiconductor switch has a capacitance which provides an additional reactive element within the first conductor loop in the form of a capacitor.

6. RF antenna or coil according to claim 1,
wherein the at least one reactive element (Rx) is each a capacitor (C1, C2, C3, C4) or an inductor (L1; L2).

7. RF antenna or coil according to claim 1,
wherein into the first conductor (11) at least one reactive element (Rx) is serially connected, or at least one parallel connection of at least two reactive elements (Rx) is serially connected.

8. RF antenna or coil according to claim 2,
wherein into the third conductor (13) at least one reactive element (Rx) is serially connected, or at least one parallel connection of at least two reactive elements (Rx) is serially connected.

9. RF antenna or coil according to claim 1,
wherein the RF antenna or coil is a TEM-type or a micro-strip antenna or coil, wherein the first conductor loop is connected serially into the resonant conductor structure or provides a connection of the resonant conductor structure to a ground plane or screen of the TEM-type or micro-strip antenna.

10. RF transmit/receive antenna arrangement comprising an RF transmit antenna or coil and an RF receive antenna or coil, at least one of these RF antennas or coils being provided in the form of an RF antenna or coil according to at least one of claims 1 to 9.

11. RF transmit/receive antenna arrangement according to claim 10,
wherein the RF transmit antenna or coil is provided in the form of an RF antenna or coil according to at least one of claims 1 to 9 for decoupling the RF transmit antenna or coil from the RF receive antenna or coil during RF signal reception, by switching the switch into its non-conducting state.

12. MR imaging system or scanner comprising an RF antenna or coil according to at least one of claims 1 to 9.
